# EUROPÄISCHE PATENTSCHRIFT

(11) **EP 1 664 811 B1**
(45) Veröffentlichungstag und Bekanntmachung des Hinweises auf die Patenterteilung: **25.06.2008**
(21) Anmeldenummer: 04762712.0
(22) Anmeldetag: 24.08.2004
(51) Int. Cl.: G01R 31/30, G01R 31/26

(54) **ELEKTRONISCHER SHALTKREIS UND VERFAHREN ZUM ERMITTELN DER FUNKTIONSFÄHIGKEIT EINES ELEKTRONISCHEN SCHALTKREISES**
ELECTRONIC CIRCUIT AND METHOD FOR DETERMINING THE OPERATIVENESS OF AN ELECTRONIC CIRCUIT
CIRCUIT DE COMMUTATION ELECTRONIQUE ET PROCEDE POUR DETERMINER LE BON FONCTIONNEMENT D'UN CIRCUIT DE COMMUTATION ELECTRONIQUE

(30) Priorität: 17.09.2003 DE 10342997
(43) Veröffentlichungstag der Anmeldung: 07.06.2006
(73) Patentinhaber: Infineon Technologies AG, 81669 München (DE)
(72) Erfinder: KERBER, Martin, 81827 München (DE); POMPL, Thomas, 84034 Landshut (DE)
(74) Vertreter: Viering, Jentschura & Partner
(86) Internationale Anmeldenummer: PCT/DE2004/001879
(87) Internationale Veröffentlichungsnummer: WO 2005/029104

(56) Entgegenhaltungen:
- US-A1- 2001 045 841
- LINDER B P ET AL: "Transistor-limited constant voltage stress of gate dielectrics" 2001 SYMPOSIUM ON VLSI TECHNOLOGY. DIGEST OF TECHNICAL PAPERS. KYOTO, JAPAN, JUNE 12 - 14, 2001, SYMPOSIUM ON VLSI TECHNOLOGY, TOKYO : JSAP, JP, 12. Juni 2001 (2001-06-12), Seiten 93-94, XP010552016 ISBN: 4-89114-012-7 in der Anmeldung erwähnt
- KACZER B ET AL: "Observation of hot-carrier-induced nFET gate-oxide breakdown in dynamically stressed CMOS circuits" INTERNATIONAL ELECTRON DEVICES MEETING 2002. IEDM. TECHNICAL DIGEST. SAN FRANCISCO, CA, DEC. 8 - 11, 2002, NEW YORK, NY : IEEE, US, 8. Dezember 2002 (2002-12-08), Seiten 171-174, XP010626016 ISBN: 0-7803-7462-2

## Beschreibung

Die Erfindung betrifft einen elektronischen Schaltkreis, eine Schaltkreis-Testanordnung sowie ein Verfahren zum Ermitteln der Funktionsfähigkeit eines elektronischen Schaltkreises.

Die Zuverlässigkeit eines Gate-Oxids in einem integrierten Halbleiterbauelement mit einem Feldeffekttransistor stößt mit Fortschreiten der Skalierung an intrinsische Belastungsgrenzen, insbesondere bei Entwicklung von Transistoren mit immer dünneren Schichten und steigenden Betriebsfeldstärken trotz kleinerer Betriebsspannungen.

Die statistische Natur des dielektrischen Durchbruchs eines Gateoxids führt zu einer breiteren statistischen Streuung der Lebensdauer des jeweiligen Halbleiterbauelements. Damit wird insbesondere bei einer großen aktiven Fläche in einem elektronischen Chip durch eine Flächenskalierung die prognostizierte Lebensdauer der Halbleiterbauelemente reduziert und nicht mehr verlässlich vorhersagbar.

Außerdem ist bei einem dünnen Dielektrikum ein dielektrischer Durchbruch durch einen deutlich geringeren Anstieg des Leckstroms charakterisiert als bei einer dickeren Dielektrikumsschicht. Der nur geringe Anstieg des Leckstroms führt bei vielen schaltungstechnischen Anwendungen lediglich zu einer Zunahme der Verlustleistung in der elektronischen Schaltung, aber nicht notwendigerweise zu einer Fehlfunktion, d.h. zu einem Ausfall der gesamten elektronischen Schaltung.

Übliche Testverfahren zum Testen einer elektronischen Schaltung bewerten die erste kleine Veränderung des durch das Gateoxid fließenden Gatestroms, nicht aber die eigentlich relevante Fehlfunktion der elektronischen Schaltung beziehungsweise des elektronischen Schaltkreises in der jeweils relevanten Schaltkreisumgebung.

Ferner ist es bekannt, die Zuverlässigkeit eines Dielektrikums mittels beschleunigter Testverfahren an einer Teststruktur zu ermitteln, die eine Parallelschaltung einer Mehrzahl identischer Grundelemente aufweist. Bei einem dünnen Dielektrikum ist die maximale Anzahl der Grundelemente durch den auftretenden hohen Leckstrom aufgrund direkten Tunnels und durch den kleinen Breakdown-Strom begrenzt.

Ein Durchbruch-Ereignis, auch bezeichnet als Breakdown-Ereignis, muss zu einem signifikanten Stromanstieg über das Grundniveau des Belastungsstroms des elektronischen Schaltkreises, im Folgenden auch bezeichnet als Stressstrom des elektronischen Schaltkreises, führen, um ausreichend sicher erkannt zu werden.

Bei einem Dielektrikum von 2,0 nm Dicke ist die maximale aktive Fläche der gesamten Teststruktur gemäß dem Stand der Technik auf 200 µm² bis 1000 µm² beschränkt.

Die auftretende Flächenbegrenzung für eine Teststruktur führt zu einer deutlich eingeschränkten Auflösung der Defektdichte und damit verbunden zu einer vergrößerten Unsicherheit bei einer Extrapolation auf Zuverlässigkeits-Anforderungen (reliability targets) unter Betriebsbedingungen eines elektronischen Schaltkreises.

Eine Verbesserung der Auflösung der Defektdichte führt zu einem erheblichen Mehraufwand in Form von benötigter Messzeit und/oder benötigtem Equipment für die Parallelmessung.

In [1] und in [2] ist beschrieben, dass bei einem dünnen Gateoxid bei Transistoren in einem elektronischen Schaltkreis der Ausfall eines oder mehrerer Transistoren in dem elektronischen Schaltkreis aufgrund eines auftretenden Durchbruchs in dem jeweiligen Gateoxid eines Feldeffekttransistors noch nicht notwendigerweise zu dem Ausfall der Funktionsfähigkeit des gesamten elektronischen Schaltkreises führt verglichen mit der Soll-Funktion des elektronischen Schaltkreises.

In [1] und in [2] ist in diesem Zusammenhang eine Ringoszillatorstruktur mit 47 zu einem Ring geschalteten Invertern beschrieben, wobei ein Inverter als ein NAND-Gatter ausgeführt ist. Dem Ringoszillator nachgeschaltet ist ein Frequenzteiler-Schaltkreis. Die Schaltkreis-Anordnung aus Ringoszillator und Frequenzteiler-Schaltkreis würde einer Belastung durch Anlegen einer elektrischen Spannung ausgesetzt und das Verhalten der Funktion der Schaltkreis-Anordnung würde untersucht.

In [3] ist der Einfluss eines Gateoxid-Durchbruchs bei einem Feldeffekttransistor in einer SRAM-Speicherzelle (**S**tatic **R**andom **A**ccess **M**emory-Speicherzelle) beschrieben.

Ferner ist aus [4] bekannt, dass bei einem durch eine Spannung belasteten Inverter, welcher einen NMOS-Feldeffekttransistor und einen PMOS-Feldeffekttransistor aufweist, die Degradation des Inverters abhängt von der Polarität der angelegten Stressspannung. Je nach Polarität der angelegten Stressspannung wird entweder der jeweilige NMOS-Feldeffekttransistor oder der jeweilige PMOS-Transistor stärker belastet und früher zerstört.

Ferner ist in [5] ein zu testender NMOS-Feldeffekttransistor mit einem Gateoxid mit einer Schichtdicke von 1,7 nm beschrieben, an dessen Gateanschluss ein PMOS-Feldeffekttransistor mit einem dickeren Gateoxid angeschlossen ist. An den Drain-Anschluss des PMOS-Feldeffekttransistors wird die Stressspannung angelegt.

Bei der in [5] beschriebenen Schaltung aus zwei Feldeffekttransistoren wurde bei einer Stressspannung von 3,4 Volt und einer Stromtreiberfähigkeit von weniger als 200 µA ein Leckstrom nach erfolgtem Durchbruch des Gateoxids in dem NMOS-Feldeffekttransistor gemessen, der kleiner war als 100 µA. Es ist in diesem Zusammenhang anzumerken, dass nur das Verhalten des Gateoxids in dem NMOS-Feldeffekttransistor bei Anlegen der Stressspannung an den PMOS-Feldeffekttransistor isoliert untersucht wurde.

In [6] wird eine integrierte Schaltungsanordnung in MOS-Technologie mit Feldeffekttransistoren offenbart, welche eine Schaltungsanordnung für das rasche Testen verschiedener Blöcke des Schaltkreises aufweist. Diese Schaltungsanordnung weist drei Transistor-Schaltergruppen auf. Eine erste Transistor-Schaltergruppe wird für das Testen eines Eingangsblocks verwendet. Eine zweite Transistor-Schaltergruppe dient zum Anschalten und Abschalten des Eingangsblocks und eines Ausgangsblocks, so dass die Blöcke gemeinsam getestet werden können, und einen dritten Block für das Testen des Ausgangsblocks.

In [7] wird ein elektrisch löschbarer und programmierbarer Festwertspeicher mit einer NAND-Zellenstruktur offenbart, welcher Speicherzellen (M) aufweist, welche auf einem N-Substrat angeordnet sind. Die Speicherzellen sind in NAND-Zellblöcke aufgeteilt, welche jeweils in Serie geschaltete Speicherzellen-Transistor-Arrays (M1 bis M4) aufweisen. Jeder der Transistoren weist ein Floating Gate (50), ein Steuer-Gate, welches an eine Wortleitung (WLi) angeschlossen ist und eine N-Typ-Diffusionsschichten (68, 70), welche als entsprechende Sources und Drains dienen, auf.

In [8] werden eine integrierte Halbleiterschaltung, die eine Schaltung zum Erzeugen einer stabilen negativen internen Versorgungsspannung für einen Funktionsschaltungsblock der Halbleiterschaltung aufweist, und ein Testverfahren für die Halbleiterschaltung beschrieben, bei dem zunächst der Funktionsschaltungsblock der Halbleiterschaltung mittels einer externen Spannungsversorgung getestet wird und ein optimaler Wert für eine Versorgungsspannung für den Funktionsschaltungsblock ermittelt wird und dann der Funktionsschaltungsblocks bei einer auf den ermittelten optimalen Wert hin regulierten internen Versorgungsspannung getestet wird.

Der Erfindung liegt das Problem zugrunde, die Zuverlässigkeit einer Gate-Isolationsschicht eines Feldeffekttransistors zu ermitteln, wobei eine produktrelevante Aussage hinsichtlich der Zuverlässigkeit eines elektronischen Schaltkreises, der den jeweiligen Feldeffekttransistor aufweist ermöglicht ist, ohne der Einschränkung hinsichtlich der Flächenbegrenzung, wie sie gemäß dem Stand der Technik gegeben ist, unterworfen zu sein.

Das Problem wird durch den elektronischen Schaltkreis, durch die Schaltkreis-Testanordnung sowie durch das Verfahren zum Ermitteln der Funktionsfähigkeit eines elektronischen Schaltkreises mit den Merkmalen gemäß den unabhängigen Patentansprüchen gelöst.

Ein elektronischer Schaltkreis weist einen Testsignal-Eingangsanschluss auf zum Anlegen eines Test-Eingangssignals. Ferner ist ein Testsignal-Ausgangsanschluss vorgesehen, an welchem ein Test-Ausgangssignal bereitstellbar ist. Zwischen den Testsignal-Eingangsanschluss und den Testsignal-Ausgangsanschluss ist eine Vielzahl von Test-Schaltungsblöcken geschaltet, wobei jeder Test-Schaltungsblock mindestens einen ersten Teil-Schaltungsblock und mindestens einen zweiten Teil-Schaltungsblock aufweist. Dies bedeutet, dass ein an den Testsignal-Eingangsanschluss angelegtes Test-Eingangssignal entsprechend der Ausgestaltung der Test-Schaltungsblöcke durch diese hindurchläuft beziehungsweise von diesem gemäß der Funktionalität der Test-Schaltungsblöcke bearbeitet wird und ausgangsseitig an den Test-Ausgangsanschluss als Test-Ausgangssignal bereitgestellt wird. Damit ist aufgrund der Kopplung der Test-Schaltungsblöcke eingangsseitig mit dem Testsignal-Eingangsanschluss und ausgangsseitig mit dem Testsignal-Ausgangsanschluss gewährleistet, dass mittels des Test-Eingangssignals die Funktionalität der Test-Schaltungsblöcke testbar ist. In dem ersten Teil-Schaltungsblock eines jeden Test-Schaltungsblocks ist mindestens ein erster Feldeffekttransistor mit einer Gate-Isolationsschicht enthalten. Ferner ist in dem zweiten Teil-Schaltungsblock eines jeden Test-Schaltungsblocks mindestens ein zweiter Feldeffekttransistor mit einer Gate-Isolationsschicht enthalten. Die Gate-Isolationsschicht eines jeden ersten Feldeffekttransistors ist dicker als die Gate-Isolationsschicht eines jeweiligen zweiten Feldeffekttransistors.

Eine Schaltkreis-Testanordnung zum Ermitteln der Funktionsfähigkeit eines elektronischen Schaltkreises weist den oben beschriebenen elektronischen Schaltkreis auf sowie eine Test-Eingangssignal-Erzeugungseinheit zum Erzeugen eines dem Testsignal-Eingangsanschluss zuzuführenden Test-Eingangssignals sowie eine Test-Ausgangssignal-Auswerteeinheit, mit der die Funktionsfähigkeit des elektronischen Schaltkreises ermittelbar ist. Ferner ist eine Betriebsspannungsquelle vorgesehen zum Bereitstellen einer Betriebsspannung, mit der der elektronische Schaltkreis betrieben wird.

Bei einem Verfahren zum Ermitteln der Funktionsfähigkeit eines elektronischen Schaltkreises, der wie oben beschrieben aufgebaut ist, wird ein Test-Eingangssignal an den Testsignal-Eingangsanschluss angelegt und das zugehörige Test-Ausgangssignal wird an dem Testsignal-Ausgangsanschluss abgegriffen. Unter Verwendung des Test-Ausgangssignals wird ermittelt, ob der elektronische Schaltkreis funktionsfähig ist oder nicht.

Bei dem elektronischen Schaltkreis wird aufgrund der Vielzahl hintereinander angeordneter Test-Schaltungsblöcke nicht nur ein einzelner Transistor hinsichtlich seiner Funktionsfähigkeit überprüft, sondern es wird das funktionale Soll-Verhalten der Gesamtheit der Test-Schaltungsblöcke getestet. Auf diese Weise ist eine produktrelevante Information hinsichtlich der Funktionsfähigkeit eines Produkts mit integrierten Halbleiterbauelementen gewährleistet.

Ferner ist aufgrund der unterschiedlichen Dicke der Gate-Isolationsschichten in den jeweiligen Teil-Schaltungsblöcken der Test-Schaltungsblöcke gewährleistet, dass nur der jeweilige zweite Feldeffekttransistor, d.h. der Feldeffekttransistor mit der dünnen Gate-Isolationsschicht hinsichtlich eines Gate-Isolationsschicht-Durchbruchs wirksam getestet und belastet wird und die Gate-Isolationsschicht des jeweiligen ersten Feldeffekttransistors, d.h. der Feldeffekttransistor mit der dickeren Gate-Isolationsschicht wird selbst nicht hinsichtlich eines möglicherweise auftretenden Gate-Isolationsschicht-Durchbruchs getestet, da die Wahrscheinlichkeit eines Gate-Isolationsschicht-Durchbruchs bei dem jeweiligen ersten Feldeffekttransistor wesentlich geringer ist als bei dem jeweiligen zweiten Feldeffekttransistor.

Anschaulich stellt somit jeweils der erste Feldeffekttransistor eine Stressquelle, anders ausgedrückt einen Treiber für den jeweiligen zweiten Feldeffekttransistor dar. Allgemein stellt jeweils der erste Teil-Schaltungsblock eine Stressquelle beziehungsweise einen Treiber für den jeweiligen zweiten Teil-Schaltungsblock dar.

Der jeweils erste Feldeffekttransistor, allgemein jeweils der erste Teil-Schaltungsblock, dient anschaulich zur Signalkonditionierung und nur der jeweilige zweite Feldeffekttransistor, anschaulich der jeweilige zweite Teil-Schaltungsblock, wird hinsichtlich des Auftretens eines möglichen Gate-Isolationsschicht-Durchbruchs getestet.

Auf diese Weise wird erfindungsgemäß anschaulich ein neues Test- und/oder Bewertungsverfahren vorgeschlagen mit einer entsprechenden Teststruktur, mit der eine realistischere Prognose für die Zuverlässigkeit eines Dielektrikums, vorzugsweise eines Gate-Dielektrikums eines Feldeffekttransistors, ermöglicht wird.

Es ist somit erstmals erfindungsgemäß erreicht, dass im Rahmen der Ermittlung der Zuverlässigkeit einer Gate-Isolationsschicht keine Flächenbegrenzung mehr besteht. Ferner werden aufgrund der vorgesehenen Vielzahl von Test-Schaltungsblöcken statistische Aussagen über die Zuverlässigkeit der Gate-Isolationsschichten in den zweiten Teil-Schaltungsblöcken ermittelt, wodurch der Aussagegehalt der gewonnenen Information erheblich verbessert wird. Dieses neue Bewertungskriterium für die Zuverlässigkeit einer Gate-Isolationsschicht insbesondere für ein dünnes Dielektrikum, ist unmittelbar produktrelevant.

Bevorzugte Ausgestaltungen der Erfindung ergeben sich aus den abhängigen Ansprüchen.

Die Gate-Isolationsschichten der ersten Feldeffekttransistoren sind gemäß einer Ausgestaltung der Erfindung um mindestens einen Faktor 1,2, besonders bevorzugt um mindestens einen Faktor 1,3, dicker als die Gate-Isolationsschichten der zweiten Feldeffekttransistoren.

Bei dieser Dimensionierung der Schichtdicken der Gate-Isolationsschichten der ersten Feldeffekttransistoren beziehungsweise der zweiten Feldeffekttransistoren ist gewährleistet, dass die Lebensdauer der ersten Feldeffekttransistoren um mindestens einen Faktor 1000 größer ist als die Lebensdauer der zweiten Feldeffekttransistoren, womit statistisch sicher gewährleistet ist, dass im Wesentlichen nur die Gate-Isolationsschicht der zweiten Feldeffekttransistoren bei entsprechender Belastung durch eine an dem elektronischen Schaltkreis anliegende Betriebsspannung jeweils durchbricht. Damit ist sichergestellt, dass jeweils der erste Teil-Schaltungsblock eine zuverlässige Stressquelle für den jeweiligen zweiten Teil-Schaltungsblock zur Signalkonditionierung des Test-Eingangssignals darstellt.

Gemäß einer Ausgestaltung der Erfindung ist die Schichtdicke der Gate-Isolationsschichten der zweiten Feldeffekttransistoren kleiner als 5 nm, besonders bevorzugt kleiner als 2 nm. Die Erfindung eignet sich insbesondere für sogenannte Dünnoxid-Feldeffekttransistoren, da die oben beschriebene Problematik der statistisch auftretenden Durchbrüche in einem Gateoxid eines Feldeffekttransistors und die nur geringe Zunahme eines Leckstroms bei auftretendem Durchbruchs eines Gate-Dielektrikums dort besondere Bedeutung gewinnt.

Bei einer Schichtdicke der Gate-Isolationsschichten der zweiten Feldeffekttransistoren von 5 nm weisen somit die ersten Feldeffekttransistoren vorzugsweise jeweils eine Gate-Isolationsschicht mindestens einer Dicke von 6 nm auf. Bei einer Schichtdicke der Gate-Isolationsschichten der zweiten Feldeffekttransistoren von 2 nm weisen die Gate-Isolationsschicht der ersten Feldeffekttransistoren vorzugsweise jeweils eine Schichtdicke von mindestens 2,4 nm auf.

Die Feldeffekttransistoren können MOS-Feldeffekttransistoren (Metal Oxide Semiconductor-Feldeffekttransistoren), besonders bevorzugt CMOS-Feldeffekttransistoren (Complementary Metal Oxide Semiconductor-Feldeffekttransistoren), sein.

Bei siliziumbasierten Feldeffekttransistoren sind die Gate-Isolationsschichten vorzugsweise aus Oxidmaterial gebildet, besonders bevorzugt aus Siliziumdioxid, alternativ aus einem Dielektrikum mit einer höheren Dielektrizitätskonstanten wie beispielsweise ein oder mehrere Übergangsmetalloxide, z.B. Aluminiumoxid (Al₂O₃), Hafniumoxid (HfO₂), und deren Silikate.

Gemäß einer Ausgestaltung der Erfindung ist es vorgesehen, das der mindestens eine erste Teil-Schaltungsblock und der mindestens eine zweite Teil-Schaltungsblock in dem jeweiligen Test-Schaltungsblock in Serie miteinander gekoppelt sind.

Der mindestens eine erste Teil-Schaltungsblock und/oder der mindestens eine zweite Teil-Schaltungsblock enthalten/enthält mindestens einen Inverter.

Durch das Vorsehen mindestens eines Inverters in den ersten Teil-Schaltungsblöcken und in den zweiten Teil-Schaltungsblöcken wird durch die jeweilige Signalinvertierung in jedem Teil-Schaltungsblock sichergestellt, dass einerseits eine Signalbearbeitung in dem Test-Schaltungsblöcken durchgeführt wird, andererseits aber auch, dass das jeweilige Teil-Ausgangssignal, welches am Ausgang des jeweiligen Test-Schaltungsblocks anliegt, die gleiche Polarität hat wie das an dem jeweiligen Test-Schaltungsblock anliegende Teil-Eingangssignal.

Ferner ist es durch das Vorsehen von Invertern ermöglicht, ohne weiteres auch das Umschalten von einem ersten Signalpegel zu einem zweiten Signalpegel zu erfassen, beispielsweise einen Übergang von einem Pegel von 3 Volt, allgemein einem High-Pegel, auf einen Pegel von 0 Volt, allgemein einem Low-Pegel, und umgekehrt.

Gemäß einer Ausgestaltung der Erfindung besteht die ersten Teil-Schaltungsblöcke jeweils aus einem ersten Inverter, in dem beide Feldeffekttransistoren, d.h. ein PMOS-Feldeffekttransistor und ein NMOS-Feldeffekttransistor dicke Gate-Isolationsschichten, d.h. dicke Gateoxide aufweisen. Gemäß dieser Ausgestaltung der Erfindung ist es vorgesehen, dass der jeweilige zweite Teil-Schaltungsblock eines jeden Test-Schaltungsblocks jeweils aus genau einem Inverter gebildet wird, wobei der jeweilige NMOS-Feldeffekttransistor und der jeweilige PMOS-Feldeffekttransistor eine dünne Gateoxidschicht, allgemein eine dünne Gate-Isolationsschicht aufweisen von vorzugsweise einer Dicke von maximal 5 nm.

Vorzugsweise ist der zweite Teil-Schaltungsblock dem ersten Teil-Schaltungsblock in dem jeweiligen Test-Schaltungsblock nachgeschaltet.

Anschaulich bilden die Vielzahl von Test-Schaltungsblöcken mit jeweils den beiden Teilschaltungsblöcken mit jeweils einem Inverter eine Pufferkette, mit denen eine produktnahe Beurteilung der Zuverlässigkeit der Gate-Isolationsschichten in integrierten Logikschaltungen ermöglicht wird. Anders ausgedrückt bedeutet dies, dass jeder Test-Schaltungsblock einen zweistufigen Inverter, vorzugsweise einen zweistufigen CMOS-Inverter, aufweist, bei dem die erste Inverterstufe mit einem dickeren Gateoxid und die zweite Inverterstufe mit dem zu beurteilenden, d.h. zu testenden dünneren Gateoxid, oder einem Gatedielektrikum mit hoher Dielektrizitätskonstanten ausgeführt ist. Die zwei Inverterketten mit unterschiedlicher Oxiddicke, d.h. eine erste Inverterkette, die gebildet wird aus den ersten Teil-Schaltungsblöcken und eine zweite Inverterkette, die gebildet wird aus den zweiten Teil-Schaltungsblöcken, sind vorzugsweise ineinander verschachtelt verschaltet.

In den zweiten Inverterstufen wird jeweils das eigentlich zu testende Gateoxid belastet, d.h. gestresst. Die vorgeschalteten ersten Inverterstufen stellen jeweils eine produktartige Ansteuerung der getesteten Inverterstufen dar, womit die Produktrelevanz der ermittelten Ergebnisse im Rahmen des Testens des elektronischen Schaltkreises sichergestellt ist. Der jeweilige erste Teil-Schaltungsblock hat ferner die Aufgabe, die Inverterfunktion der jeweiligen zweiten Inverterstufe zu kompensieren, ohne selbst wesentlich zur Breakdown-Verteilung, d.h. zur statistischen Verteilung des Auftretens von Durchbrüchen in den Gate-Isolationsschichten, beizutragen. Dies wird dadurch erreicht, dass die jeweilige erste Inverterstufe in einem dickeren Gateoxid ausgeführt ist. Die dafür erforderliche Technologie wird in heute üblichen Technologiegenerationen in Standard-Prozessen bereitgestellt.

Die Pegelinversion, d.h. die Inversion der jeweiligen elektrischen Spannung, die an dem jeweiligen Teil-Schaltungsblock anliegt, durch die jeweilige erste Inverterstufe stellt sicher, dass jede Inverterstufe mit Transistoren mit dünnem Gateoxid mit derselben elektrischen Spannung belastet wird. Es können somit je nach Anlegen der Eingangsspannung an die jeweilige erste Inverterstufe, d.h. je nach gewähltem Pegel der angelegten Eingangsspannung, alle NMOS-Feldeffekttransistoren oder alle PMOS-Feldeffekttransistoren zur Belastung wahlweise selektiert werden.

Die Pufferkette stellt anschaulich eine einfache integrierte Schaltung dar, an der sich eine logische Soll-Grundfunktion testen lässt.

Bei einer Ausgestaltung der erfindungsgemäßen Schaltkreis-Testanordnung ist es vorgesehen, dass die Amplitude der Betriebsspannung variierbar ist. Die Test-Ausgangssignal-Auswerteeinheit ist in diesem Fall derart eingerichtet, dass sie die minimale Amplitude der Betriebsspannung ermitteln kann, bei der der elektronische Schaltkreis noch funktionsfähig ist.

Durch Variation der Amplitude der anliegenden Betriebsspannung an den elektronischen Schaltkreis wird ein neues Bewertungskriterium für die Zuverlässigkeit, insbesondere für Dielektrika, angegeben, welches unmittelbar produktrelevant ist. Somit wird erfindungsgemäß eine Funktion ermittelt, bei der die kleinste Betriebsspannung, d.h. die minimale Versorgungsspannung, bei der noch die jeweilige logische Funktion der Test-Schaltungsblöcke korrekt ausgeführt wird, als Funktion der Stressbelastung, angegeben wird.

Alternativ ist es vorgesehen, dass die Betriebsspannungsquelle derart eingerichtet ist, dass die Frequenz der Betriebsspannung variierbar ist und dass die Test-Ausgangssignal-Auswerteeinheit derart eingerichtet ist, dass unter Verwendung der jeweilig anliegenden Frequenz der Betriebsspannung ermittelt wird, bei welcher Frequenz der elektronische Schaltkreis noch funktionsfähig ist.

Erfindungsgemäß gilt auch nicht mehr die Flächenbeschränkung wie gemäß dem Stand der Technik, da nicht mehr der Breakdown-Strom im Verhältnis zum Leckstrom bei Stressbedingungen bewertet wird. Vielmehr kann die logische Funktion an einer beliebig langen Inverterkette beurteilt werden, die Struktur sollte lediglich niederohmig angeschlossen werden, so dass dieselbe Stressspannung an jedem Device, d.h. vorzugsweise an jedem Feldeffekttransistor mit dünner Gate-Isolationsschicht, anliegt.

In entsprechender Weise ist für das erfindungsgemäße Verfahren in einer Ausgestaltung der Erfindung vorgesehen, dass unter Variieren der Amplitude einer angelegten Betriebsspannung ermittelt wird, ab bzw. bei welcher minimalen Betriebsspannung der elektronische Schaltkreis funktionsfähig ist.

Alternativ ist es vorgesehen, dass unter Variieren der Frequenz einer angelegten Betriebsspannung ermittelt wird, ob der elektronische Schaltkreis funktionsfähig ist.

Anschaulich kann die Erfindung darin gesehen werden, dass Dickoxid-Inverter und Dünnoxid-Inverter zu Pufferketten zur Untersuchung der Zuverlässigkeit von dünnen Dielektrika, d.h. von dünnen Oxiden kombiniert werden.

Anders als in herkömmlichen Schaltungselementen erlaubt die erfindungsgemäße Pufferkette die gezielte Belastung von NMOS-Feldeffekttransistoren oder PMOS-Feldeffekttransistoren unter produktartiger Umgebung, löst die Einschränkung der Flächenbegrenzung bei dünnen Dielektrika gemäß dem Stand der Technik und stellt mit der Bewertung der logischen Funktion beziehungsweise der Funktionsfähigkeit der Test-Schaltungsblöcke ein produktrelevantes Bewertungskriterium dar.

Der elektronische Schaltkreis kann auf einem Wafer integriert sein, beispielsweise in einem zu bildenden elektronischen Chip, alternativ in einem Sägerahmen eines Wafers, in dem eine Vielzahl elektronischer Chips gefertigt werden.

Ausführungsbeispiele der Erfindung sind in den Figuren dargestellt und werden im Folgenden näher erläutert. Gleiche oder ähnliche Komponenten sind in den Figuren gegebenenfalls mit identischen Bezugszeichen versehen.

Es zeigen
- Figur 1: einen zu testenden elektronischen Schaltkreis gemäß einem ersten Ausführungsbeispiel der Erfindung;
- Figur 2: eine Schaltkreis-Testanordnung gemäß einem ersten Ausführungsbeispiel der Erfindung;
- Figur 3: eine schematische Layout-Darstellung einer Inverterstufe eines zu untersuchenden Schaltkreises gemäß Figur 1; und
- Figuren: 4A und 4B zu testende elektronische Schaltkreise gemäß einem zweiten Ausführungsbeispiel der Erfindung.

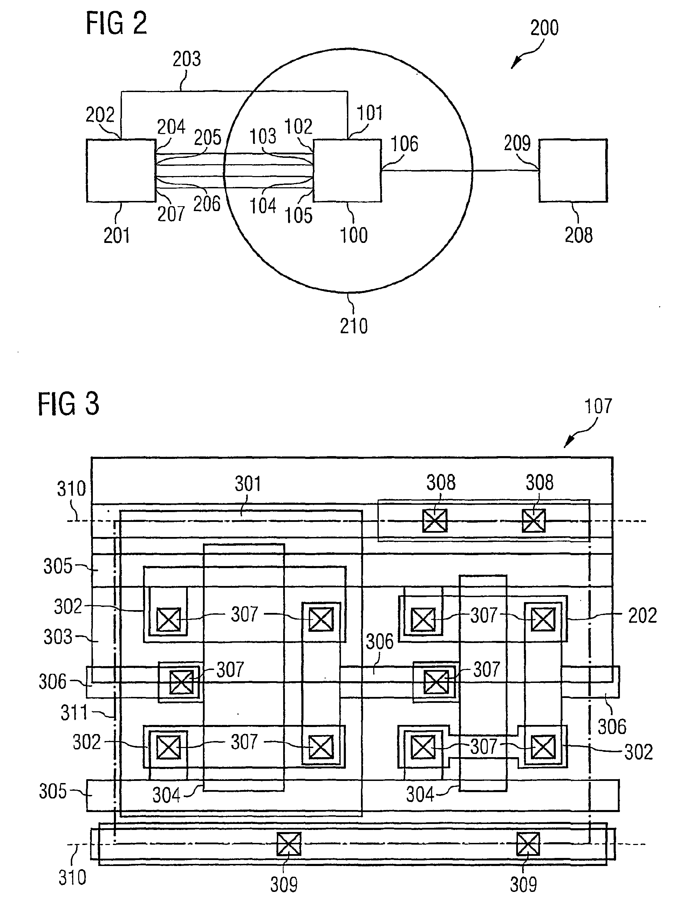

**Fig.2** zeigt einen Schaltkreis-Testanordnung 200 gemäß einem ersten Ausführungsbeispiel der Erfindung.

Die Schaltkreis-Testanordnung 200 zum Ermitteln der Funktionsfähigkeit eines elektronischen Schaltkreises 100 weist einen Signalgenerator 201 zum Erzeugen eines elektrischen Testsignals sowie zum Bereitstellen einer Betriebsspannung auf.

An einem ersten Ausgang 202 wird von dem Signalgenerator 201 ein Testsignal 203 bereitgestellt und einem Testsignal-Eingangsanschluss 101 des elektronischen Schaltkreises 100, welcher mit dem ersten Ausgangsanschluss 202 des Signalgenerators 201 gekoppelt ist, zugeführt.

Ferner weist der Signalgenerator 201 vier Betriebsspannungsanschlüsse 204, 205, 206, 207 auf, wobei an einem ersten Betriebsspannungsanschluss 204 ein erstes Betriebspotenzial V_{DD}, an einem zweiten Betriebsspannungsanschluss ein zweites Betriebspotenzial V_{SS}, an einem dritten Betriebsspannungsanschluss 206 ein WannenPotenzial V_{well} sowie an einem vierten Betriebsspannungsanschluss 207 ein Substratpotenzial V_{sub} bereitgestellt wird.

Die vier Betriebsspannungsanschlüsse 204, 205, 206, 207 des Signalgenerators 201 sind mit zugehörigen vier Eingangsanschlüssen 102, 103, 104, bzw. 105 gekoppelt.

Ferner weist die Schaltkreis-Testanordnung 200 eine Test-Ausgangssignal-Auswerteeinheit 208, eingerichtet als Personal Computer, auf, welcher mittels einer Eingangs-/Ausgangsschnittstelle 209 mit einem Testsignal-Ausgangsanschluss 106 des elektronischen Schaltkreises 100 gekoppelt ist.

Der zu testende elektronische Schaltkreis 100 ist gemäß diesem Ausführungsbeispiel in einem elektronischen Chip (nicht gezeigt) eines Wafers 210 integriert.

Alternativ ist es vorgesehen, dass der elektronische Schaltkreis 100 in einem Sägerahmen des Wafers 210 angeordnet ist.

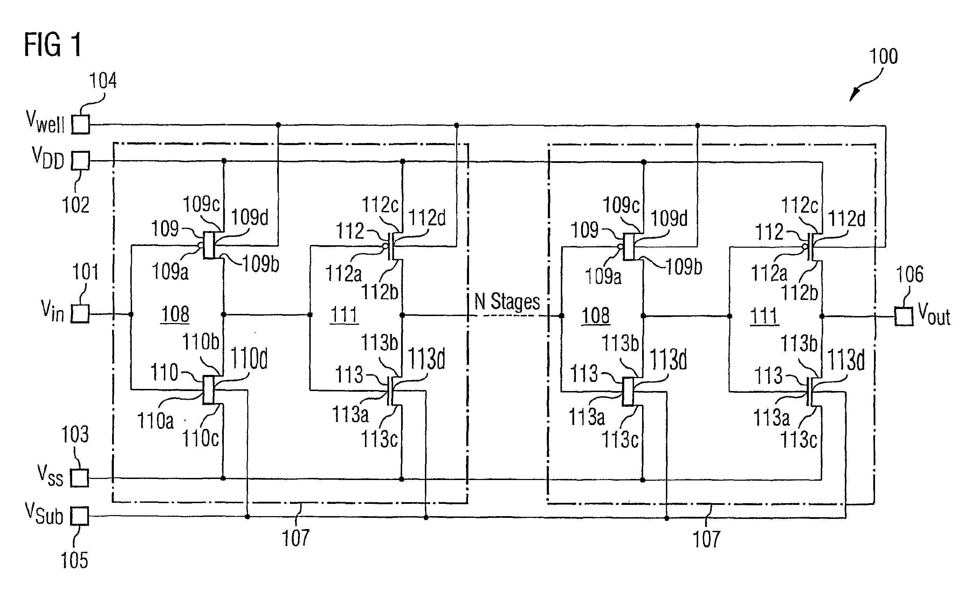

Im Folgenden wird der Aufbau des zu untersuchenden elektronischen Schaltkreises 100 anhand von **Fig.1** näher beschrieben.

Der zu testende elektronische Schaltkreis 100 weist N Inverterstufen auf, welche in Serie geschaltet sind, wobei jeweils zwei einander unmittelbar benachbart angeordnete Inverterstufen ein Inverterstufenpaar 107 als Test-Schaltungsblock bilden. Dies bedeutet, dass N/2 Inverterstufenpaare 107 in dem zu testenden elektronischen Schaltkreis 100 vorgesehen sind.

Eine erste Inverterstufe 108 eines jeden Inverterstufenpaars 107 weist einen PMOS-Feldeffekttransistor 109 sowie einen NMOS-Feldeffekttransistor 110 auf, wobei die Gateoxide, d.h. die Siliziumdioxidschichten zur Isolierung der Gateschicht des jeweiligen Feldeffekttransistors von dessen Kanalbereich, eine Dicke von 6 nm aufweisen. Anders ausgedrückt bedeutet dies, dass die erste Inverterstufe aus Feldeffekttransistoren mit dickem Gateoxid gebildet ist.

Der ersten Inverterstufe 108 jeweils in Signalflussrichtung nachgeschaltet in einem Inverterstufenpaar 107 ist eine zweite Inverterstufe 111, welche ebenfalls einen PMOS-Feldeffekttransistor 112 und einen NMOS-Feldeffekttransistor 113 aufweist.

Die Gateoxidschicht, d.h. gemäß diesem Ausführungsbeispiel der Erfindung die Siliziumdioxidschicht, der beiden Feldeffekttransistoren 112, 113 zur Isolation der Gateschicht von dem Kanalbereich der jeweiligen Feldeffekttransistoren 112, 113 ist gemäß diesem Ausführungsbeispiel der Erfindung 5 nm dick.

Die Gateanschlüsse 109a, 110a der beiden Feldeffekttransistoren 109, 110 der ersten Inverterstufe 108 sind mit dem Testsignal-Eingangsanschluss 101 gekoppelt, so dass das von dem Signalgenerator 201 erzeugte Testsignal direkt an die Gateanschlüsse 109a, 110a der Feldeffekttransistoren 109, 110 der ersten Inverterstufe 108 angelegt wird.

Ein erster Source-Drain-Anschluss 109b des PMOS-Feldeffekttransistors 109 der ersten Inverterstufe 108 ist mit einem ersten Source-Drain-Anschluss 110b des NMOS-Feldeffekttransistors 110 der ersten Inverterstufe gekoppelt.

Ein erster Source-Drain-Anschluss 112b des PMOS-Feldeffekttransistors 112 der zweiten Inverterstufe 111 ist mit einem ersten Source-Drain-Anschluss 113b des NMOS-Feldeffekttransistors 113 der zweiten Inverterstufe 111 gekoppelt.

Alle zweiten Source-Drain-Anschlüsse 109c, 112c aller PMOS-Feldeffekttransistoren 109, 112 aller Inverterstufen 108, 111 ist mit dem ersten Betriebsspannungsanschluss 102 des zu testenden elektronischen Schaltkreises 100 gekoppelt, so dass das erste Betriebspotenzial V_{DD} an den jeweiligen ersten Source-Drain-Anschluss 109c, 112c des PMOS-Feldeffekttransistors 109, 112 des elektronischen Schaltkreises 100 angelegt wird.

Ferner sind die Wannenanschlüsse 109d, 112d aller PMOS-Feldeffekttransistoren 109 und 112 aller Inverterstufen 108, 111 mit dem dritten Betriebsspannungsanschluss 104 des elektronischen Schaltkreises 100 gekoppelt, so dass das jeweilige Wannenpotenzial V_{well} an den jeweiligen Wannenanschluss 109d, 112d eines PMOS-Feldeffekttransistors 109d, 112d aller Inverterstufen 108, 111 des elektronischen Schaltkreises 100 angelegt wird.

Alle zweiten Source-Drain-Anschlüsse 110c, 113c aller NMOS-Feldeffekttransistoren 110, 113 aller Inverterstufen 108, 111, ist mit dem zweiten Betriebsspannungsanschluss 103 gekoppelt. Somit wird an den jeweiligen zweiten Source-Drain-Anschluss 110c, 113c eines jeden NMOS-Feldeffekttransistors 110, 113 das zweite Betriebspotenzial V_{SS} angelegt.

Die Substratanschlüsse 110d, 113d aller NMOS-Feldeffekttransistoren 110, 113 aller Inverterstufen 108, 111 sind mit dem vierten Betriebsspannungsanschluss 105 gekoppelt, so dass an den jeweiligen Substratanschluss 110d eines jeden NMOS-Feldeffekttransistors 110, 113 das Substratpotenzial V_{sub} angelegt wird.

Die beiden Gateanschlüsse 112a, 113a der beiden Feldeffekttransistoren 112, 113 der zweiten Inverterstufe 111 sind mit dem ersten Source-Drain-Anschluss 109b des PMOS-Feldeffekttranisistor 109 der ersten Inverterstufe 108 sowie mit dem ersten Source-Drain-Anschluss 110b des NMOS-Feldeffekttransistors 110 der ersten Inverterstufe 108 gekoppelt.

In entsprechender Weise sind die anderen Inverterstufenpaare 107 mit dem Betriebsspannungsanschlüssen 102, 103, 104, 105 gekoppelt und miteinander in Serie geschaltet, so dass jeweils die beiden Gateanschlüsse 109a, 110a der Feldeffekttransistoren 109, 110 der ersten Inverterstufe 108 mit den beiden ersten Source-Drain-Anschlüssen 112b, 113b der Feldeffekttransistoren der zweiten Inverterstufe 111 des jeweils in Signalflussrichtung vorangegangen Inverterstufenpaares 107 gekoppelt sind.

Die ersten Source-Drain-Anschlüsse 112b, 113b der Feldeffekttransistoren 112, 113 der zweiten Inverterstufe 111 des in Signalflussrichtung innerhalb des elektronischen Schaltkreises 100 letzten Inverterstufenpaares 107 ist mit dem Testsignal-Ausgangsanschluss 106 gekoppelt, an welchem von dem elektronischen Schaltkreis 100 eine Testsignal-Ausgangsspannung Vₒᵤₜ bereitgestellt wird.

Es ist in diesem Zusammenhang anzumerken, dass der elektronische Schaltkreis 100 eine beliebige Anzahl von Inverterstufenpaaren 107 und damit eine beliebige geradzahlige Anzahl von n Inverterstufen, d.h. N = 2, 10, 100, 1000, 10000..., wobei mit N die Anzahl der Inverterstufen in den elektronischen Schaltkreis 100 bezeichnet wird, aufweisen kann. Ferner ist darauf hinzuweisen, dass vorzugsweise die Abmessung der NMOS-Feldeffekttransistoren 113 der zweiten Inverterstufe 111 und der PMOS-Feldeffekttransistoren 112 der zweiten Inverterstufe 111, d.h. die NMOS-Feldeffekttransistoren 113 und PMOS-Feldeffekttransistoren 112 der Dünnoxid-Inverter unterschiedlich sind, vorzugsweise weisen sie eine geringe Weite bei unterschiedlicher Länge auf.

**Fig.3** zeigt eine schematische Layout-Darstellung eines Inverterstufenpaares 107 mit einer ersten Inverterstufe 108 und einer zweiten Inverterstufe 111.

In der linken Hälfte ist die erste Inverterstufe 108 und in der rechten Hälfte der Fig.3 die zweite Inverterstufe 111 dargestellt.

Der Bereich mit dickem Oxid, d.h. mit einer Gateoxidschicht der Dicke 6 nm ist in Fig.3 mit dem Bezugszeichen 301 bezeichnet.

Die aktiven Bereiche der Feldeffekttransistoren 109, 110, 112, 113 sind mit dem Bezugszeichen 302 versehen.

Die N-Wanne für die PMOS-Feldeffekttransistoren 109, 112 des Inverterstufenpaares 107 ist mit dem Bezugszeichen 303 versehen.

Die Bereiche aus Polysilizium sind mit dem Bezugszeichen 304 bezeichnet.

Die Leiterbahnen der ersten Metallisierungsebene, an welche die Source-Drain-Anschlüsse der Feldeffekttransistoren angeschlossen sind, sind mit dem Bezugszeichen 305 bezeichnet.

Die Leiterbahnen der zweiten Metallisierungsebene M2, an welche die Gateanschlüsse der Feldeffekttransistoren angeschlossen sind, sind mit dem Bezugszeichen 306 versehen.

Mit dem Bezugszeichen 307 sind die Kontaktlöcher zur Kontaktierung der Leiterbahnen mit den Gateanschlüssen und den Source-Drain-Anschlüssen der Feldeffekttransistoren bezeichnet.

Mit dem Bezugszeichen 308 sind die Kontaktlöcher zur Kontaktierung der N-Wanne bezeichnet.

Mit dem Bezugszeichen 309 sind die Kontaktlöcher zur Kontaktierung der NMOS-Feldeffekttransistoren, d.h. insbesondere der Substratanschlüsse der NMOS-Feldeffekttransistoren mit dem Substrat bezeichnet.

Bezugszeichen 310 bezeichnet die Symmetrieachse einer von dem Inverterstufenpaar 107 in dem Layout gebildeten Einheitszelle 311.

Von dem Signalgenerator 201 wird jeweils ein elektronisches Testsignal eines vorgegebenen Testsignalprofils an die Gateanschlüsse 109a, 110a der Feldeffekttransistoren 109, 110 der ersten Inverterstufe 108 angelegt.

Das erste Betriebspotenzial V_{DD} wird von dem Signalgenerator 201 variiert. Der erste Betriebsspannungsanschluss 102, an den das erste Betriebspotenzial V_{DD}, d.h. die Spannungsversorgung, dem elektronischen Schaltkreis 100 zugeführt wird, stellt anschaulich den Stresspin dar, d.h. den Anschluss, über den der Stressstrom, der die zu testenden und zu belastenden Feldeffekttransistoren mit dünnen Gateoxiden belasten soll, zugeführt wird.

Erfindungsgemäß wird das erste Betriebspotenzial V_{DD} variiert und es wird jeweils nach erfolgter Belastung mittels der Test-Ausgangssignal-Auswerteeinheit 208 die minimale Versorgungsspannung bestimmt, d.h. minimale Betriebsspannung, bei der noch die logische Funktion, welche durch die Inverterstufen 108, 111 realisiert wird, korrekt ausgeführt wird.

Steigt die minimale Versorgungsspannung über eine vorgebbare, von den Prozesstechnologien abhängige Spannungsschwelle an, dann bedeutet dies, dass die Leckströme in den Feldeffekttransistoren zu groß werden, was schließlich auf aufgetretene Durchbrüche in den Gateoxiden der Feldeffekttransistoren mit dünnen Gateoxiden schließen lässt.

Es ist in diesem Zusammenhang anzumerken, dass die spezifischen Spannungsschwellen für jeden Wafer unterschiedlich sein kann und abhängig ist von den verwendeten Materialien und den eingesetzten Herstellungsprozessen. Die Spannungsschwellen sind somit für jeden Wafer empirisch zu ermitteln und die Test-Ausgangssignal-Auswerteeinheit 208 ist entsprechend zu kalibrieren bzw. einzustellen.

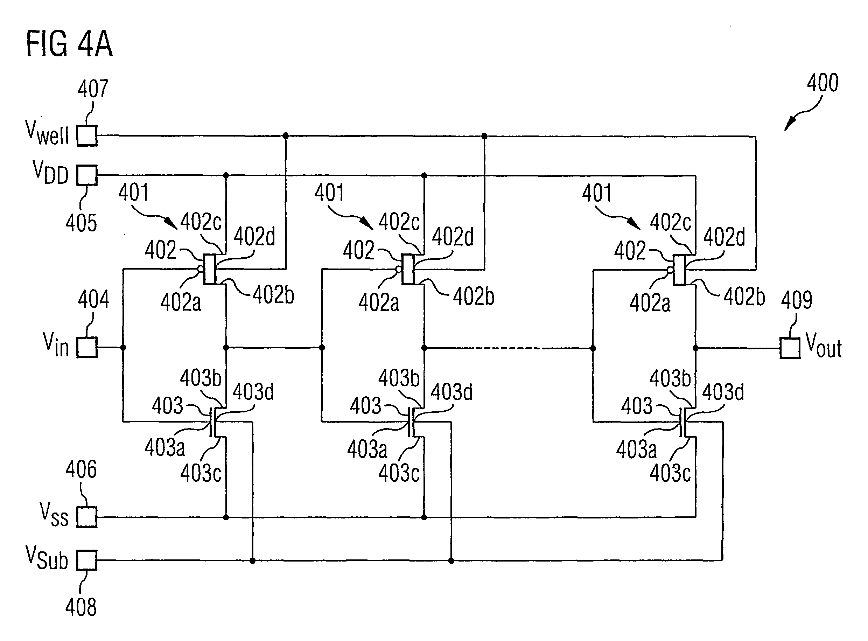

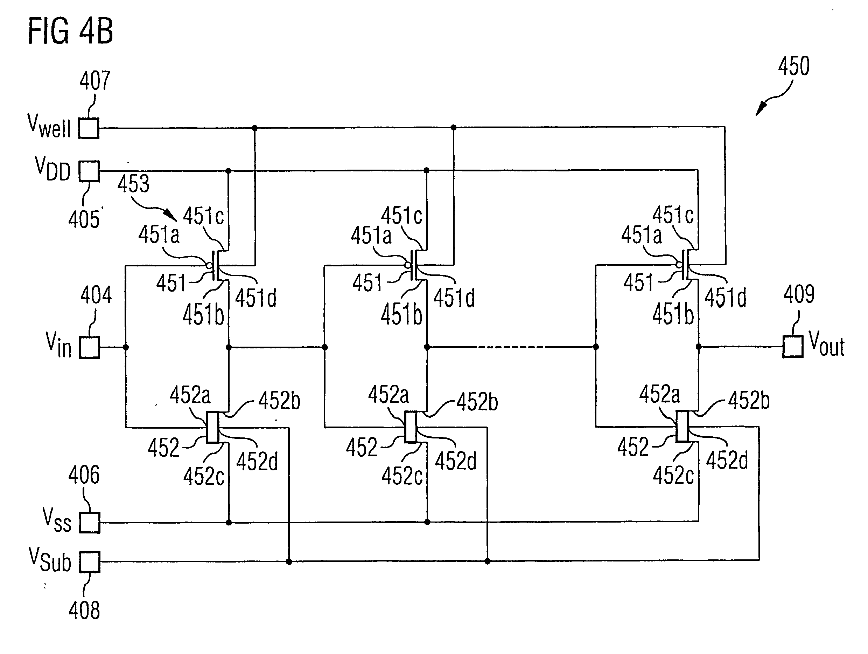

In den **Fig.4a** und **Fig.4b** sind zwei elektronische Schaltkreise 400, 450 gemäß einem zweiten Ausführungsbeispiel der Erfindung dargestellt.

Im Unterschied zu dem elektronischen Schaltkreis 100 gemäß dem ersten Ausführungsbeispiel der Erfindung weist der erste elektronische Schaltkreis 400 gemäß dem zweiten Ausführungsbeispiel der Erfindung identische Inverterstufen 401 auf, welche jeweils einen PMOS-Feldeffelzttransistors 402 mit dickem Gateoxid, d.h. mit einem Gateoxid der Dicke von 6 nm aufweist sowie einen NMOS-Feldeffekttransistor 403, mit einer Gateoxidschicht der Dicke von 5 nm, d.h. mit einem dünnen Gateoxid.

Die Verschaltung ist identisch mit der Verschaltung der Inverterstufen gemäß dem ersten Ausführungsbeispiel der Erfindung, d.h. die Gateanschlüsse 402a, 403a der Feldeffekttransistoren 402, 403 sind mit einem Testsignal-Eingangsanschluss 404 gekoppelt. Die ersten Source-Drain-Anschlüsse 402b, 403b der Feldeffekttransistoren 402, 403 sind miteinander sowie mit den Gateanschlüssen 402a, 403a der in Signalflussrichtung nachfolgenden Feldeffekttransistoren 402, 403 der nächsten Inverterstufe 401 angeschlossen.

Der zweite Source-Drain-Anschluss des PMOS-Feldeffekttransistors 402a mit dickem Gateoxid ist jeweils mit einem ersten Betriebsspannungsanschluss 405 gekoppelt, an welchen das erste Betriebspotenzial V_{DD} angelegt wird.

Der zweite Source-Drain-Anschluss 403c des NMOS-Feldeffekttransistors 403 mit dünnem Gateoxid jeder Inverterstufe 401 ist mit einem zweiten Betriebsspannungsanschluss 406 gekoppelt, an welchen ein zweites Betriebspotenzial V_{SS} angelegt wird.

Der Wannenanschluss 402d eines jeden PMOS-Feldeffekttransistors 402 ist mit einem dritten Betriebsspannungsanschluss 407 gekoppelt, an welchen das Wannenpotenzial V_{well} angelegt wird.

Der Substratanschluss 403d eines jeden NMOS-Feldeffekttransistors 403 der Inverter 401 ist mit einem vierten Betriebsspannungsanschluss 408 gekoppelt, an welchem das Substratpotenzial V_{sub} angelegt wird.

Die Durchführung der Ermittlung der Zuverlässigkeit der Gatedielektrika erfolgt in entsprechender Weise wie gemäß dem ersten Ausführungsbeispiel mittels eines nicht gezeigten Signalgenerators und einer entsprechenden Test-Ausgangssignal-Auswerteeinheit.

Die ersten Source-Drain-Anschlüsse 402b, 403b der Feldeffekttransistoren 402, 403 der in Signalflussrichtung letzten Inverterstufe 401 in dem elektronischen Schaltkreis 400 sind mit einem Testsignal-Ausgangsanschluss 409 gekoppelt, an welchem das Test-Ausgangssignal Vₒᵤₜ bereitgestellt wird.

Die zu testenden Feldeffekttransistoren sind gemäß diesem Ausführungsbeispiel der Erfindung die NMOS-Feldeffekttransistoren 403.

Zum Testen von Gateoxiden von PMOS-Feldeffekttransistoren ist gemäß dem zweiten Ausführungsbeispiel der Erfindung ein zweiter elektronischer Schaltkreis 450, wie er in Fig.4b dargestellt ist, vorgesehen.

Die Schaltungsstruktur ist identisch mit der des ersten elektronischen Schaltkreises 400 gemäß Fig.4a mit dem Unterschied, dass in diesem Fall die PMOS-Feldeffekttransistoren 451 als Transistoren mit dünnem Gateoxid, d.h. mit einem Gateoxid der Dicke von 5 nm vorgesehen ist und die NMOS-Feldeffekttransistoren 502 sind mit einer Dicke der jeweiligen Gateoxidschicht von 6 nm, d.h. mit einem dicken Gateoxid, ausgebildet.

Die Gateanschlüsse 451a, 452a der Feldeffekttransistoren 451, 452 sind bei dem ersten Inverter 453 mit dem Testsignal-Eingangsanschluss 404 gekoppelt und bei den nachfolgenden Inverterstufen mit den beiden ersten Source-Drain-Anschlüssen 451b, 452b der Feldeffekttransistoren 451, 452 des in Signalflussrichtung jeweils vorangegangen Inverters 453.

Der zweite Source-Drain-Anschluss 451c eines jeden PMOS-Feldeffekttransistors 451 ist jeweils mit dem zweiten Betriebsspannungsanschluss 405 gekoppelt und der zweite Source-Drain-Anschluss 452c eines jeden NMOS-Feldeffekttransistors 452 ist mit dem dritten Betriebsspannungsanschluss 406 gekoppelt.

Der Wannenanschluss 451 eines jeden PMOS-Feldeffekttransistors 451 ist mit dem dritten Betriebsspannungsanschluss 407 gekoppelt und der Substratanschluss 452d eines jeden NMOS-Feldeffekttransistors 452 ist mit dem vierten Betriebsspannungsanschluss 408 gekoppelt.

Die ersten Source-Drain-Anschlüsse 451b, 452b des in Signalflussrichtung letzten Inverters 453 sind mit dem Testsignal-Ausgangsanschluss 409 gekoppelt.

In diesem Dokument sind folgende Veröffentlichungen zitiert:
[1] B. Kaczer et al, Impact of MOSFET gate oxide breakdown on digital circuit operation and reliability, IEEE Transactions on Electron Devices, Volume 49, No. 3, Seiten 500 bis 505, März 2002;
[2] B. Kaczer et al, Impact of MOSFET oxide breakdown on digital circuit operation and reliability, IEDM 00, Seiten 553 bis 556, 2000;
[3] R. Rodriguez et al, The impact of gate-oxide breakdown on SRAM stability, IEEE Electron Device Letters, Volume 23, No. 9, Seiten 559 bis 561, September 2002;
[4] R. Rodriguez et al, A model for gate-oxide breakdown in CMOS in Inverters, IEEE Electron Device Letters, Volume 24, No. 2, Seiten 114 bis 116, February 2003;
[5] B.P. Linder, Transistor-Limited constant voltage stress of gate dielectrics, Symposium on VLSI Technology Digest of Technical Papers, Seiten 93 bis 94, 2001.
[6] DE 29 05 271 A1
[7] DE 38 86 722 T2
[8] US 2001/045841 A1

### Bezugszeichenliste

- 100: Elektronischer Schaltkreis
- 101: Testsignal-Eingangsanschluss
- 102: erster Betriebsspannungsanschluss
- 103: zweiter Betriebsspannungsanschluss
- 104: dritter Betriebsspannungsanschluss
- 105: vierter Betriebsspannungsanschluss
- 106: Testsignal-Ausgangsanschluss
- 107: Inverterstufenpaar
- 108: erste Inverterstufe
- 109: PMOS-Feldeffekttransistor erste Inverterstufe
- 109a: Gateanschluss PMOS-Feldeffekttransistor erste Inverterstufe
- 109b: erster Source-Drain-Anschluss PMOS-Feldeffekttransistor erste Inverterstufe
- 109c: zweiter Source-Drain-Anschluss PMOS-Feldeffekttransistor erste Inverterstufe
- 109d: Wannenanschluss PMOS-Feldeffekttransistor erste Inverterstufe
- 110: NMOS-Feldeffekttransistor erste Inverterstufe
- 110a: Gateanschluss NMOS-Feldeffekttrarisistor erste Inverterstufe
- 110b: erster Source-Drain-Anschluss NMOS-Feldeffekttransistor erste Inverterstufe
- 110c: zweiter Source-Drain-Anschluss NMOS-Feldeffekttransistor erste Inverterstufe
- 110d: Substratanschluss NMOS-Feldeffekt transistor erste Inverterstufe
- 112: PMOS-Feldeffekttransistor zweite Inverterstufe
- 112a: Gateanschluss PMOS-Feldeffekttransistor zweite Inverterstufe
- 112b: erster Source-Drain-Anschluss PMOS-Feldeffekttransistor zweite Inverterstufe
- 112c: zweiter Source-Drain-Anschluss PMOS-Feldeffekttransistor zweiter Inverterstufe
- 112d: Wannenanschluss PMOS-Feldeffekttransistor zweite Inverterstufe
- 113: NMOS-Feldeffekttransistor zweite Inverterstufe
- 113a: Gateanschluss NMOS-Feldeffekttransistor zweite Inverterstufe
- 113b: erster Source-Drain-Anschluss NMOS-Feldeffekttransistor zweite Inverterstufe
- 113c: zweiter Source-Drain-Anschluss NMOS-Feldeffekttransistor zweite Inverterstufe
- 113d: Substratanschluss NMOS-Feldeffekttransistor zweite Inverterstufe

- 200: Schaltkreis-Testanordnung
- 201: Signalgenerator
- 202: Testsignal-Ausgangsanschluss
- 203: Testsignal
- 204: erster Betriebsspannungsanschluss Signalgenerator
- 205: zweiter Betriebsspannungsanschluss Signalgenerator
- 206: dritter Betriebsspannungsanschluss Signalgenerator
- 207: vierter Betriebsspannungsanschluss Signalgenerator
- 208: Test-Ausgangssignal-Auswerteeinheit
- 209: Eingangs-/Ausgangsschnittstelle
- 210: Wafer

- 301: dickes Oxid
- 302: aktiver Bereich
- 303: N-Wanne
- 304: Polysilizium
- 305: erste Metallschicht
- 306: zweite Metallschicht
- 307: Kontaktloch
- 308: Kontaktloch zu N-Wanne
- 309: Kontaktloch zu Substrat
- 310: Symmetrieachse
- 311: Einheitszelle

- 400: erster elektronischer Schaltkreis
- 401: Inverterstufe
- 402: PMOS-Feldeffekttransistor
- 402a: Gateanschluss PMOS-Feldeffekttransistor
- 402b: erster Source-Drain-Anschluss PMOS-Feldeffekttransistor
- 402c: zweiter Source-Drain-Anschluss PMOS-Feldeffekttransistor
- 402d: Wannenanschluss PMOS-Feldeffekttransistor
- 403: NMOS-Feldeffekttransistor
- 403a: Gateanschluss NMOS-Feldeffekttransistor
- 403b: erster Source-Drain-Anschluss NMOS-Feldeffekttransistor
- 403c: zweiter Source-Drain-Anschluss NMOS-Feldeffekttransistor
- 403d: Substratanschluss NMOS-Feldeffekttransistor
- 404: Testsignal-Eingangsanschluss
- 405: erster Betriebsspannungsanschluss elektronischer Schaltkreis
- 406: zweiter Betriebsspannungsanschluss elektronischer Schaltkreis
- 407: dritter Betriebsspannungsanschluss elektronischer Schaltkreis
- 408: vierter Betriebsspannungsanschluss elektronischer Schaltkreis
- 409: Testsignal-Ausgangsanschluss

- 450: zweiter elektronischer Schaltkreis
- 451: PMOS-Feldeffekttransistor
- 451a: Gateanschluss PMOS-Feldeffekttransistor
- 451b: erster Source-Drain-Anschluss PMOS-Feldeffekttransistor
- 451c: zweiter Source-Drain-Anschluss PMOS-Feldeffekttransistor
- 451d: Wannenanschluss PMOS-Feldeffekttransistor
- 452: NMOS-Feldeffekttransistor
- 452a: Gateanschluss NMOS-Feldeffekttransistor
- 452b: erster Source-Drain-Anschluss NMOS-Feldeffekttransistor
- 452c: zweiter Source-Drain-Anschluss NMOS-Feldeffekttransistor
- 452d: Substratanschluss NMOS-Feldeffekttransistor
- 453: Inverter

## Patentansprüche

1. Elektronischer Schaltkreis (100),
• mit einem Testsignal-Eingangsanschluss (101) zum Anlegen eines Test-Eingangssignals (Vᵢₙ),
• mit einem Testsignal-Ausgangsanschluss (106), an dem ein Test-Ausgangssignal (Vₒᵤₜ) bereitstellbar ist,
• mit einer Vielzahl von Test-Schaltungsblöcken (107), wobei jeder Test-Schaltungsblock (107) mindestens einen ersten Teil-Schaltungsblock (108) und mindestens einen zweiten Teil-Schaltungsblock (111) aufweist,
• wobei die Test-Schaltungsblöcke (107) zwischen den Testsignal-Eingangsanschluss und den Testsignal-Ausgangsanschluss (106) geschaltet sind, so dass mittels des Test-Eingangssignals (Vᵢₙ) die Funktionalität der Test-Schaltungsblöcke testbar ist,
• wobei der mindestens eine erste Teil-Schaltungsblock (108) und der mindestens eine zweite Teil-Schaltungsblock (111) in dem jeweiligen Test-Schaltungsblock (107) in Serie miteinander gekoppelt sind,
• wobei der mindestens eine erste Teil-Schaltungsblock (108) und der mindestens eine zweite Teil-Schaltungsblock (111) jeweils mindestens einen Inverter enthalten,
• wobei in den ersten Teil-Schaltungsblöcken (108) jeweils mindestens ein erster Feldeffekttransistor (109, 110) mit einer Gate-Isolationsschicht enthalten ist,
• wobei in den zweiten Teil-Schaltungsblöcken (111) jeweils mindestens ein zweiter Feldeffekttransistor (112, 113) mit einer Gate-Isolationsschicht enthalten ist,
• wobei die Gate-Isolationsschicht eines jeden ersten Feldeffekttransistors (109, 110) dicker ist als die Gate-Isolationsschicht eines jeweiligen zweiten Feldeffekttransistors (112, 113), so dass die ersten Feldeffekttransistoren (109, 110) jeweils als Treiber eines jeweiligen zweiten Feldeffekttransistors (112, 113) eingerichtet sind.

2. Elektronischer Schaltkreis (100) gemäß Anspruch 1, bei dem die Gate-Isolationsschichten der ersten Feldeffekttransistoren (109, 110) um mindestens einen Faktor 1,2 dicker sind als die Gate-Isolationsschichten der zweiten Feldeffekttransistoren (109, 110).

3. Elektronischer Schaltkreis (100) gemäß Anspruch 1 oder 2, bei dem die Schichtdicke der Gate-Isolationsschichten der zweiten Feldeffekttransistoren (112, 113) kleiner ist als 6 nm.

4. Elektronischer Schaltkreis (100) gemäß einem der Ansprüche 1 bis 3, bei dem die Schichtdicke der Gate-Isolationsschichten der ersten Feldeffekttransistoren (109, 110) größer ist als 10 nm.

5. Elektronischer Schaltkreis (100) gemäß einem der Ansprüche 1 bis 4, bei dem die Feldeffekttransistoren (109, 110, 112, 113) MOS-Feldeffekttransistoren sind.

6. Elektronischer Schaltkreis (100) gemäß Anspruch 5, bei dem die Feldeffekttransistoren (109, 110, 112, 113) CMOS-Feldeffekttransistoren sind.

7. Elektronischer Schaltkreis (100) gemäß einem der Ansprüche 1 bis 6, bei dem die Gate-Isolationsschichten Oxidmaterial aufweisen.

8. Elektronischer Schaltkreis (100) gemäß Anspruch 7, bei dem die Gate-Isolationsschichten Siliziumdioxid, ein oder mehrere Übergangsmetalloxide oder deren Silikate enthalten.

9. Elektronischer Schaltkreis (100) gemäß Anspruch 7 oder 8,
bei dem der zweite Teil-Schaltungsblock (111) dem ersten Teil-Schaltungsblock (108) in dem jeweiligen Test-Schaltungsblock (107) nachgeschaltet ist.

10. Schaltkreis-Testanordnung (200) zum Ermitteln der Funktionsfähigkeit eines elektronischen Schaltkreises (100),
• mit einem elektronischen Schaltkreis (100) gemäß einem der Ansprüche 1 bis 9,
• mit einer Test-Eingangssignal-Erzeugungseinheit (201) zum Erzeugen eines dem Testsignal-Eingangsanschluss (101) zuzuführenden Test-Eingangssignals (203),
• mit einer Test-Ausgangssignal-Auswerteeinheit (208), mit der die Funktionsfähigkeit des elektronischen Schaltkreises (100) ermittelbar ist,
• mit einer Betriebsspannungsquelle (201) zum Bereitstellen einer Betriebsspannung (V_{DD}).

11. Schaltkreis-Testanordnung (200) gemäß Anspruch 10,
• bei der die Betriebsspannungsquelle (201) derart eingerichtet ist, dass die Amplitude der Betriebsspannung variierbar ist, und
• bei der die Test-Ausgangssignal-Auswerteeinheit (208) derart eingerichtet ist, dass sie die minimale Amplitude der Betriebsspannung (V_{DD}) ermitteln kann, bei der der elektronische Schaltkreis (100) funktionsfähig ist.

12. Schaltkreis-Testanordnung (200) gemäß Anspruch 10,
bei der die Betriebsspannungsquelle (201) derart eingerichtet ist, dass die Frequenz der Betriebsspannung (V_{DD}) variierbar ist.

13. Verfahren zum Ermitteln der Funktionsfähigkeit eines elektronischen Schaltkreises (100), welcher aufweist
einen Testsignal-Eingangsanschluss (101) zum Anlegen eines Test-Eingangssignals (Vᵢₙ),
einen Testsignal-Ausgangsanschluss (106), an dem ein Test-Ausgangssignal (Vₒᵤₜ) bereitstellbar ist,
eine Vielzahl von Test-Schaltungsblöcken (107), wobei jeder Test-Schaltungsblock (107) mindestens einen ersten Teil-Schaltungsblock (108) und mindestens einen zweiten Teil-Schaltungsblock (111) aufweist,
wobei die Test-Schaltungsblöcke (107) zwischen den Testsignal-Eingangsanschluss (101) und den Testsignal-Ausgangsanschluss (106) geschaltet sind, so dass mittels des Test-Eingangssignals (Vᵢₙ) die Funktionalität der Test-Schaltungsblöcke (107) testbar ist,
wobei der mindestens eine erste Teil-Schaltungsblock (108) und der mindestens eine zweite Teil-Schaltungsblock (111) in dem jeweiligen Test-Schaltungsblock (107) in Serie miteinander gekoppelt sind,
wobei der mindestens eine erste Teil-Schaltungsblock (108) und der mindestens eine zweite Teil-Schaltungsblock (111) jeweils mindestens einen Inverter enthalten,
wobei in den ersten Teil-Schaltungsblöcken (108) jeweils mindestens ein erster Feldeffekttransistor (109, 110) mit einer Gate-Isolationsschicht enthalten ist,
wobei in den zweiten Teil-Schaltungsblöcken (111) jeweils mindestens ein zweiter Feldeffekttransistor (112, 113) mit einer Gate-Isolationsschicht enthalten ist,
wobei die Gate-Isolationsschicht eines jeden ersten Feldeffekttransistors (109, 110) dicker ist als die Gate-Isolationsschicht eines jeweiligen zweiten Feldeffekttransistors (112, 113),
• bei dem ein Test-Eingangssignal (Vᵢₙ) an den Testsignal-Eingangsanschluss (101) angelegt wird,
• bei dem an dem Testsignal-Ausgangsanschluss (106) ein zugehöriges Test-Ausgangssignal (Vₒᵤₜ) abgegriffen wird,
• bei dem unter Verwendung des Test-Ausgangssignals (Vₒᵤₜ) ermittelt wird, ob der elektronische Schaltkreis funktionsfähig ist.

14. Verfahren gemäß Anspruch 13,
bei dem unter Variieren der Amplitude einer angelegten Betriebsspannung (V_{DD}) ermittelt wird, ab welcher minimalen Betriebsspannung (V_{DD}) der elektronische Schaltkreis (100) funktionsfähig ist.

15. Verfahren gemäß Anspruch 13,
bei dem unter Variieren der Frequenz einer angelegten Betriebsspannung (V_{DD}) ermittelt wird, ob der elektronische Schaltkreis (100) funktionsfähig ist.

## Claims

1. An electronic circuit (100)
• comprising a test signal input terminal (101) for applying a test input signal (vᵢₙ),
• comprising a test signal output terminal (106), at which a test output signal (vₒᵤₜ) can be provided,
• comprising a multiplicity of test circuit blocks (107), each test circuit block (107) having at least one first sub-circuit block (108) and at least one second sub-circuit block (111),
• the test circuit blocks (107) being connected between the test signal input terminal (101) and the test signal output terminal (106), so that the functionality of the test circuit blocks can be tested by means of the test input signal (Vᵢₙ),
• the at least one first sub-circuit block (108) and the at least one second sub-circuit block (111) in the respective test-circuit block (107) are serially coupled with one another,
• the at least one first sub-circuit block (108) and the at least second sub-circuit block (111) respectively containing at least one inverter,
• the first sub-circuit blocks (108) containing at least one first field effect transistor (109, 110) with a gate insulation layer,
• the second sub-circuit blocks (111) containing at least one second field effect transistor (112, 113) with a gate insulation layer,
• the gate insulation layer of each first field effect transistor (109, 110) being thicker than the gate insulation layer of a respective second field effect transistor (112, 113), so that the first field effect transistors (109, 110) are configured as a driver of a respective second field effect transistor (112, 113).

2. The electronic circuit (100) as claimed in claim 1,
in which the gate insulation layers of the first field effect transistors (109, 110) are at least a factor of 1.2 thicker than the gate insulation layers of the second field effect transistors (109, 110).

3. The electronic circuit (100) as claimed in claim 1 or 2,
in which the layer thickness of the gate insulation layers of the second field effect transistors (112, 113) is less than 6 nm.

4. The electronic circuit (100) as claimed in one of claims 1 to 3,
in which the layer thickness of the gate insulation layers of the first field effect transistors (109, 110) is greater than 10 nm.

5. The electronic circuit (100) as claimed in one of claims 1 to 4,
in which the field effect transistors (109, 110, 112, 113) are MOS field effect transistors.

6. The electronic circuit (100) as claimed in claim 5,
in which the field effect transistors (109, 110, 112, 113) are CMOS field effect transistors.

7. The electronic circuit (100) as claimed in one of claims 1 to 6,
in which the gate insulation layers have oxide material.

8. The electronic circuit (100) as claimed in claim 7,
in which the gate insulation layers contain silicon dioxide, one or more transition metal oxides or the silicates thereof.

9. The electronic circuit (100) as claimed in one of claims 7 to 8,
in which the second sub-circuit block (111) is downstream to the first sub-circuit block (108) in the respective test circuit block (107).

10. A circuit test arrangement (200) for determining the operativeness of an electronic circuit (100),
• comprising an electronic circuit (100) as claimed in one of claims 1 to 9,
• comprising a test input signal generating unit (201) for generating a test input signal (203) to be fed to the test signal input terminal (101),
• comprising a test output signal evaluation unit (208), by means of which the operativeness of the electronic circuit (100) can be determined,
• comprising an operating voltage source (201) for providing an operating voltage (V_{DD}).

11. The circuit test arrangement (200) as claimed in claim 10,
• in which the operating voltage source (201) is configured in such a way that the amplitude of the operating voltage can be varied, and
• in which the test output signal evaluation unit (208) is configured in such a way that it can determine the minimum amplitude of the operating voltage (V_{DD}) for which the electronic circuit (100) is operative.

12. The circuit test arrangement (200) as claimed in claim 10,
in which the operating voltage source (201) is configured in such a way that the frequency of the operating voltage (V_{DD}) can be varied.

13. A method for determining the operativeness of an electronic circuit (100), having
a test signal input terminal (101) for applying a test input signal (Vᵢₙ),
a test signal output terminal (106), at which a test output signal (Vₒᵤₜ) can be provided,
a multiplicity of test circuit blocks (107), each test circuit block (107) having at least one first sub-circuit block (108) and at least one second sub-circuit block (111),
the test circuit blocks (107) being connected between the test signal input terminal (101) and the test signal output terminal (106), so that the functionality of the test circuit blocks (107) can be tested by means of the test input signal (Vᵢₙ),
the at least one first sub-circuit block (108) and the at least one second sub-circuit block (111) are serially coupled with one another in the respective test-circuit block (107),
the at least one first sub-circuit block (108) and the at least one second sub-circuit block (111) respectively containing at least one inverter,
the first sub-circuit blocks (108) respectively containing at least one first field effect transistor (109, 110) with a gate insulation layer,
the second sub-circuit blocks (111) respectively containing at least one second field effect transistor (112, 113) with a gate insulation layer,
the gate insulation layer of each first field effect transistor (109, 110) being thicker than the gate insulation layer of a respective second field effect transistor (112, 113),
• in which a test input signal (Vᵢₙ) is applied to the test signal input terminal (101),
• in which an associated test output signal (vₒᵤₜ) is tapped off at the test signal output terminal (106),
• in which the test output signal (vₒᵤₜ) is used to determine whether the electronic circuit is operative.

14. The method as claimed in claim 13,
in which the amplitude of an applied operating voltage (V_{DD}) is varied to determine the minimum operating voltage (V_{DD}) starting from which the electronic circuit (100) is operative.

15. The method as claimed in claim 13,
in which the frequency of an applied operating voltage (V_{DD}) is varied to determine whether the electronic circuit (100) is operative.

## Revendications

1. Circuit ( 100 ) électronique
• comprenant une borne ( 101 ) d'entrée de signal de test, pour appliquer un signal ( Vᵢₙ ) d'entrée de test,
• comprenant une borne ( 106 ) de sortie de signal de test sur laquelle un signal ( Vₒᵤₜ ) de sortie de signal de test est disponible,
• comprenant une pluralité de blocs ( 107 ) de circuits de test, chaque bloc ( 107 ) de circuit de test ayant au moins un premier sous-bloc ( 108 ) de circuit et au moins un deuxième sous-bloc ( 111 ) de circuit,
• les blocs ( 107 ) de circuit de test étant montés entre la borne d'entrée de signal de test et la borne ( 106 ) de sortie de signal de test, de manière à pouvoir tester la fonctionnalité des blocs de circuit de test au moyen du signal ( Vᵢₙ ) d'entrée de test,
• dans lequel le au moins un premier sous-bloc ( 108 ) de circuit et le au moins un deuxième sous-bloc ( 111 ) de circuit sont montés en série entre eux dans le bloc ( 107 ) de circuit de test respectif,
• dans lequel le au moins un premier sous-bloc ( 108 ) de circuit et le au moins un deuxième sous-bloc ( 111 ) de circuit comportent respectivement au moins un inverseur,
• dans lequel, dans les premiers sous-blocs ( 108 ) de circuit, est contenu respectivement au moins un premier transistor ( 109, 110 ) à effet de champ ayant une couche d'isolation de grille,
• dans lequel, dans les deuxièmes sous-blocs ( 111 ) de circuit, est contenu respectivement au moins un deuxième transistor ( 112, 113 ) à effet de champ ayant une couche d'isolation de grille,
• dans lequel la couche d'isolation de grille de chaque premier transistor ( 109, 110 ) à effet de champ est plus épaisse que la couche d'isolation de grille de chaque deuxième transistor ( 112, 113 ) à effet de champ, de sorte que les premiers transistors ( 109, 110 ) à effet de champ sont agencés respectivement comme étage d'attaque d'un deuxième transistor ( 112, 113 ) à effet de champ.

2. Circuit ( 100 ) électronique suivant la revendication 1,
dans lequel les couches d'isolation de grille des premiers transistors ( 109, 110 ) à effet de champ sont plus épaisses d'au moins un facteur de 1,2 que les couches d'isolation de grille des deuxièmes transistors ( 109, 110 ) à effet de champ.

3. Circuit ( 100 ) électronique suivant la revendication 1 ou 2, dans lequel l'épaisseur des couches d'isolation de grille des deuxièmes transistors ( 112, 113 ) à effet de champ est plus petite que 6 nm.

4. Circuit ( 100 ) électronique suivant l'une des revendications 1 à 3,
dans lequel l'épaisseur des couches d'isolation de grille des premiers transistors ( 109, 110) à effet de champ est plus grande que 10 nm.

5. Circuit ( 100 ) électronique suivant l'une des revendications 1 à 4,
dans lequel les transistors ( 109, 110, 112, 113 ) à effet de champ sont des transistors à effet de champ MOS.

6. Circuit ( 100 ) électronique suivant la revendication 5,
dans lequel les transistors ( 109, 110, 112, 113 ) à effet de champ sont des transistors à effet de champ CMOS.

7. Circuit ( 100 ) électronique suivant l'une des revendications 1 à 6,
dans lequel les couches d'isolation de grille comportent du matériau en oxyde.

8. Circuit ( 100 ) électronique suivant la revendication 7,
dans lequel les couches d'isolation de grille contiennent du dioxyde de silicium, un ou plusieurs oxydes de métaux de transition ou leurs silicates.

9. Circuit ( 100 ) électronique suivant la revendication 7 ou 8,
dans lequel le deuxième sous-bloc ( 111 ) de circuit est monté en aval du premier sous-bloc ( 108 ) de circuit dans le bloc ( 107 ) respectif de circuit de test.

10. Circuit ( 200 ) de test de circuit pour déterminer l'aptitude à fonctionner d'un circuit ( 100 ) électronique,
• comprenant un circuit ( 100 ) électronique suivant l'une des revendications 1 à 9,
• comprenant une unité ( 201 ) de production d'un signal d'entrée de test pour produire un signal ( 203 ) d'entrée de test à envoyer à la borne ( 101 ) d'entrée de signal de test,
• comprenant une unité ( 208 ) d'évaluation du signal de sortie de test, par laquelle l'aptitude à fonctionner du circuit ( 100 ) électronique peut être déterminée,
• comprenant une source ( 201 ) de tension de fonctionnement pour mettre à disposition une tension ( V_{DD} ) de fonctionnement.

11. Dispositif ( 200 ) de test de circuit suivant la revendication 10,
• dans lequel la source ( 201 ) de tension de fonctionnement est telle que l'amplitude de la tension de fonctionnement peut être modifiée, et
• dans lequel l'unité ( 208 ) d'exploitation du signal de sortie de test est telle qu'elle peut déterminer l'amplitude minimum de la tension ( V_{DD} ) de fonctionnement pour laquelle le circuit ( 100 ) électronique est apte à fonctionner.

12. Dispositif ( 200 ) de test de circuit suivant la revendication 10, dans lequel la source ( 201 ) de tension de fonctionnement est telle que la fréquence de la tension ( V_{DD} ) de fonctionnement peut être modifiée.

13. Procédé de détermination de l'aptitude à fonctionner d'un circuit ( 100 ) électronique qui a une borne ( 101 ) d'entrée de signal de test pour appliquer un signal ( Vᵢₙ) d'entrée de test,
une borne ( 106 ) de sortie de signal de test sur laquelle un signal ( Vₒᵤₜ ) de sortie de test est disponible,
une pluralité de blocs ( 107 ) de circuits de test, chaque bloc ( 107 ) de circuit de test ayant au moins un premier sous-bloc ( 108 ) de circuit et au moins un deuxième sous-bloc ( 111 ) de circuit,
les blocs ( 107 ) de circuit de test étant montés entre la borne d'entrée de signal de test et la borne ( 106 ) de sortie de signal de test, de manière à pouvoir tester la fonctionnalité des blocs de circuits de test au moyen du signal ( Vᵢₙ ) d'entrée de test,
dans lequel le au moins un premier sous-bloc ( 108 ) de circuit et le au moins un deuxième sous-bloc ( 111 ) de circuit sont montés en série entre eux dans le bloc ( 107 ) de circuit de test respectif,
dans lequel le au moins un premier sous-bloc ( 108 ) de circuit et le au moins un deuxième sous-bloc ( 111 ) de circuit comportent respectivement au moins un inverseur,
dans lequel, dans les premiers sous-blocs ( 108 ) de circuit, est contenu respectivement au moins un premier transistor ( 109, 110 ) à effet de champ ayant une couche d'isolation de grille,
dans lequel, dans les deuxièmes sous-blocs ( 111 ) de circuit, est contenu respectivement au moins un deuxième transistor ( 112, 113 ) à effet de champ ayant une couche d'isolation de grille,
dans lequel la couche d'isolation de grille de chaque premier transistor ( 109, 110 ) à effet de champ est plus épaisse que la couche d'isolation de grille de chaque deuxième transistor ( 112, 113 ) à effet de champ,
• dans lequel on applique un signal ( Vᵢₙ ) d'entrée de test à la borne ( 101 ) d'entrée de signal de test,
• dans lequel on prélève un signal ( Vₒᵤₜ ) de sortie de test associé à la borne ( 106 ) de sortie de signal de test,
• dans lequel on détermine si le circuit électronique est apte à fonctionner en utilisant le signal ( Vₒᵤₜ ) de sortie de test.

14. Procédé suivant la revendication 13,
dans lequel, en faisant varier l'amplitude d'une tension ( V_{DD} ) de fonctionnement appliquée, on détermine à partir de quelle tension ( V_{DD} ) de fonctionnement minimum le circuit ( 100 ) électronique est apte à fonctionner.

15. Procédé suivant la revendication 13,
dans lequel, en faisant varier la fréquence d'une tension ( V_{DD} ) de fonctionnement appliquée, on détermine si le circuit ( 100 ) électronique est apte à fonctionner.
